# EUROPEAN PATENT SPECIFICATION

(11) **EP 0 945 987 B1**
(45) Date of publication and mention of the grant of the patent: **01.02.2006**
(21) Application number: 99105938.7
(22) Date of filing: 24.03.1999
(51) Int. Cl.: H03M 1/10

(54) **Process for the linearization of the transfer characteristic of an analog-to-digital converter and a respective circuit**
Verfahren zur Linearisierung der Übertragungskennlinie eines A/D-Wandlers sowie eine Schaltung dafür
Procédé de linéarisation de la caractéristique de transfert d'un convertisseur A/N et circuit pour celui-ci

(30) Priority: 26.03.1998 IT MI980630
(43) Date of publication of application: 29.09.1999
(73) Proprietor: Siemens Mobile Communications S.p.A., 20126 Milano (IT)
(72) Inventor: Gazzoli, Giuseppe, 26100 Cremona (IT); Gatti, Umberto, 27100 Pavia (IT)
(74) Representative: Giustini, Delio

(56) References cited:
- EP-A- 0 370 661
- US-A- 4 903 026
- DENT A C ET AL: "LINEARIZATION OF ANALOG-TO-DIGITAL CONVERTERS" IEEE TRANSACTIONS ON CIRCUITS AND SYSTEMS, IEEE INC. NEW YORK, US, vol. 37, no. 6, 1 June 1990 (1990-06-01), pages 729-737, XP000149008
- GATTI U ET AL: "Improving the linearity in high-speed analog-to-digital converters" CIRCUITS AND SYSTEMS, 1998. ISCAS '98. PROCEEDINGS OF THE 1998 IEEE INTERNATIONAL SYMPOSIUM ON MONTEREY, CA, USA 31 MAY-3 JUNE 1998, NEW YORK, NY, USA,IEEE, US, 31 May 1998 (1998-05-31), pages 17-20, XP010289594 ISBN: 0-7803-4455-3

## Description

### Technical Field

The present invention relates to the field of converting electrical signals in a digital form, and more precisely to a circuit for the linearization of the transfer characteristic of an analog-to-digital converter.

The parameters marking the good functioning of an analog-to-digital converter are multiple among which the most important ones are without any doubt:
·· the maximum conversion speed, or the maximum sampling frequency admitted by the specifications which limits the bandwidth of the treatable signal;
·· the maximum bandwidth of the input signal which limits the maximum sampling frequency;
·· the maximum dynamic amplitude of the input signal, and finally
·· the output signal-to-noise ratio due to the quantization noise, to the sampling clock jitter and to a parameter known as SFDR (Spurious Free Dynamic Range) which indicates the value in dBFS (dB Full Scale) of the ratio between the amplitude of the harmonic at maximum amplitude and the maximum amplitude of an input test signal.

The last parameter (SFDR) indicates the degree of linearity of the transfer characteristic of the converter, and it gets a significant importance in applications where a high linearity is requested, like in the sector of cellular telephony which is a specialistic competence of the applicant. The latest evolutions in this field foresee indeed the implementation of a digital broadband receiver which due to the adopted special architecture requires that all components of the entire amplification/conversion chain will present the requisites to have a strongly linear transfer characteristic. It is therefore a fundamental thing, that the A/D converter on its side does not introduce any considerable distortion. In this context, the requisites related to the SFDR which the A/D converter should present to satisfy the specifications GSM 900 MHz and DCS 1800 MHz turn out to be of about 95 and 100 dBFS.

An A/D converter suitable to satisfy the needs illustrated before is different from those normally found in the market, mainly due to the difficulty of combining at contained costs high operating speeds, input broadband and an optimum linearity; all these requisites have to be present at the same time in an A/D converter suitable for the use in the above-mentioned receiver. On the other hand the ad hoc realization of a similar converter would imply significant difficulties and costs, so that the way to be adopted is certainly that to fall back on the best commercial devices suitable to satisfy the speed and input broadband requirements, looking at the same time for a technique of linearization of the characteristic which will make the parameter SFDR fall within the wanted limits.

### Background Art

A known art which achieves this objective is for example described in the paper entitled "Linearization of Analog-to-Digital Converters", by A. C. DENT and COLIN F. N. COWAN, published in IEEE TRANSACTIONS ON CIRCUITS AND SYSTEMS, Vol. 37, N° 6, of June 1990, pages 729 - 737.

The technique described in the mentioned paper consists in the application of statistic means in order to trace back to the real transfer characteristic of the A/D converter under examination with the aim to exploit the obtained information to generate a new characteristic which better approximates the ideal one. The applied statistic method foresees to send to the input of the A/D converter a training signal with a known probability distribution of the amplitude, for example a sinusoid. Due to its not perfectly linear transfer characteristic, the converter distorts the known probability distribution according to a modality which may be evidenced by the direct observation of the outgoing codes. It is in fact possible to put the last ones in a histogram of the frequency distribution of the codes themselves having in abscissa said codes and in ordinate the relative frequency with which those appear at the output. The histogram obtained in this way will be used in the known method of the "Code Density", which supplies the most probable threshold levels, which together set up the real transfer characteristic. This way of proceeding is described for example in the following articles:
- "Dynamic Testing and Diagnostics of A/D Converters", by M. Vanden Bossche, J. Schoukens and J. Renneboog, published in IEEE Trans. CAS, Vol. 33, N° 8, August 1986, pages 775 - 785.
- "Full Speed Testing of A/D Converters", by J. Doemberg, H. S. Lee and D. A. Hodges, published in IEEE J. Solid-State Circuits, Vol. SC-19, December 1984, pages 820 - 827.

Once the most probable threshold levels have been acquired, the value of the maximum admitted shifting between points of the real and ideal characteristic will be defined through a correction algorithm called "Threshold Tracking", above which the code at N bits in output of the A/D converter will be substituted by a new code, also at N bits, belonging to the ideal characteristic. The characteristic thus obtained is therefore as a whole closer to the ideal one. The "Threshold Tracking" algorithm is mentioned in the first cited article, see Fig. 10, and described with more details in the article by A.C. Dent and C.F.N. Cowan, entitled "High Resolution Analogue to Digital Conversion for Telecommunications", published in IEEE Coll. Dig. N° 1987/92, November 1987, pages 2/1-2/5. Finally, the "Threshold Tracking" algorithm makes it possible to carry out a mapping operation of all codes generated by the A/D converter whose characteristic has to be linearized in a new set of codes of a linearized characteristic which will be written in a not volatile random access memory (RAM) used on-line in the way of a look-up-table to generate corrected codes in correspondence of codes to be corrected used as reading addresses.

The European patent application EP-A-0370661, titled: "Self-calibrating pipelined subranging analog-to-digital converter" discloses an architecture comprising a faster pipelined subranging A/D converter (with m-bit digital output), a slower but more precise delta-sigma (Δ-Σ) on-chip A/D converter (with (m+2)-bit digital output) working in parallel to the first one for providing the reference for calibration, and a calibration stage that upon receiving digital words from the two A/D converters operates in such a way to minimize the non-linearity of the faster A/D converter due to component mismatches. The latter converter includes a pipeline of elemental stages each of which comprises a low-resolution flash A/D sub-converter, a D/A converter, and a unity-gain buffer providing reference voltage to the next stage. The calibration stage interpolates a piecewise-linear curve of the transfer characteristic of the pipelined A/D converter for calculating the error with respect to the reference A/D used for calibration. Four-segment approximation is indicated. For the computation of the error the following circuit are provided: a subtractor, an averaging circuit, a dual-port 100-bit static RAM to store provisional non-linearity information, and lastly an arithmetic unit which computes the gain error. The latter is then subtracted from the digital output of the pipelined A/D converter in parallel with data conversion.

### Drawbacks of the Background Art

With the exception of EP-A-0370661, the above-mentioned linearization technique allows to linearize the transfer characteristic of an A/D converter with a minimum error that will be made equal in module to a less significant bit (LSB) of the code word generated by the converter itself. This is explicitly said in the cited articles and seems to be obvious by the fact that the number of bits of both characteristics, before and after the linearization remains identical. From this fact derives a remaining not acceptable nonlinearity for the particular recent applications highlighted in the mobile radio sector, which makes the above-mentioned techniques integrally inapplicable. Furthermore, the acquisition of the information necessary to achieve the linearization takes place in an initial step which turns out apart compared to the continuous functioning of the converter. Therefore it turns out to be impossible to conciliate the continuous functioning with this calibration step, as it is necessary to send to the A/D converter a training signal rather than the actual signal to acquire the above-mentioned information.

The self-calibrated A/D converter described in EP-A-0370661, which represents the nearest prior art, overcomes all the aforementioned drawbacks because allows minimum errors lower than LSB and calibration during on-line operation, making the test signal unnecessary. Notwithstanding that, the calibration stage is still too complicated especially for the presence of the two counters and the arithmetic unit which is needed to compute the gain error.

### Object of the Invention

The object of the present invention is therefore to overcome the drawbacks of the nearest prior art and indicating a self-calibrated A/D converter having a simpler and less expensive calibration stage.

In order to achieve this object the subject of the present invention is a circuit for the linearization of the transfer characteristic of an analog-to-digital converter, as described in the claims.

The linearization circuit of the invention foresees the use of a slower but more precise reference A/D converter in parallel to the first one to be linearized, and a calibration stage including two identical RAMs (Random Access Memory), a memory buffer (register), and a selection logic for alternating the role of the two RAMs in writing and reading cycle. It can be appreciated the great simplicity of the calibration stage which makes the arithmetic unit of the nearest prior art completely unnecessary, so as a great deal of additional circuitry. The surprising simplicity of the alternative embodiment of the invention is due to the fact that the explicit computation of the gain error is altogether avoided and all the drawbacks of the prior art are overcome. Advantageously, the 16-bit words of the reference A/D against the 12-bit words of the main A/D allows a great deal of linearization. The circuitry of the invention enables the use of commercial analog-to-digital converters of any types in contexts where SFDR values of about 90 - 100 dBFS and broadband are required. The fact the second A/D converter is slower has not any particular influence on the adaptive operation, because during the time used to update completely a mapping RAM the variations in the transfer characteristic of the A/D induced by the aging and thermal drift turn out to be imperceptible. The derived advantage consists in the production of systems which do not need anymore periodical recalibrations, which in this case would even be even more onerous than the cost of the additional A/D converter since it would be necessary to equip a processor ad hoc.

### Brief Description of the Drawings

Further purposes and advantages of the present invention will become clear by the detailed description of a preferred but not limiting embodiment illustrated with reference to the alleged drawings, where:

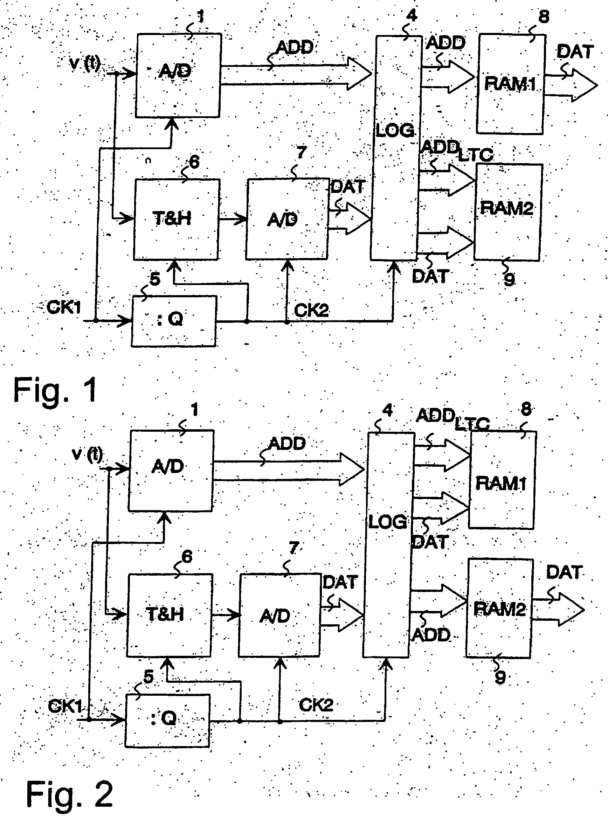

- **Figures 1** and **2** show a block scheme of the linearization circuit of the present invention where two memory blocks RAM1 and RAM2, respectively, alternate during the operation on line and during linearization.

### Detailed Description of a preferred embodiment of the Invention

Figure 1 shows a first analog-to-digital converter 1 which receives at the input an analog line signal v(t) to be digitally converted upon the timing action of a clock CK1, and from which comes out 12-bit digital words forwarded on a bus ADD to a first input of a logic unit 4. The clock CK1 arrives moreover at a frequency divider 5 to be divided by an integer number Q obtaining a clock CK2 for timing: a sample-and-hold circuit 6, a second analog-to-digital converter 7, and a logic unit 4. The analog signal v(t) is forwarded to the input of the sample-and-hold 6, and the resulting samples reaches the input of a second A/D converter 7 in order to be converted into 16-bit digital words transiting on a bus DAT directed towards a second input of the logic unit 4. The latter has three outputs, two of which for the bus ADD and for its replication ADD_{LTC} and a third one for bus DAT. The busses ADD and ADD_{LTC} at the first two outputs of the logic unit 4 join the address input of two respective random access memories (RAM) 8 and 9, respectively; while the bus DAT joins the data input of the memory 9. That is true in the operating situation shown in Fig 1 where RAM 9 will be only written and RAM 8 will be only read. The selection logic (4) together with the two RAMs 8 and 9 might be assumed as a calibration stage of the transfer characteristic (gain) of the analog-to-digital converter 1.

Fig. 2 differs from Fig. 1 only for the fact that in relation to the two RAMs 8 and 9 the writing and reading operations alternate; logic 4 provides for the scope which is not illustrated by a special figure, but its realization will be very easy for those skilled in the art after having learned from the following description the relative operation.

In normal operation the second A/D converter 7 is much slower but much more precise than the A/D converter 1; its SFDR achieves from the real beginning the values admitted by the project specifications mentioned in the introduction. The frequency of the clock CK2 will be obtained dividing by **Q** the frequency of clock CK1. The sample&hold 6 picks up a sample of the signal v(t) and keeps it memorised throughout the duration of a period of the clock CK2 used by the A/D converter 7 to complete the conversion. In reality, the same A/D converter 7 comprises an own sample&hold circuit with an analog input band with a width which is compatible with the frequency of the clock CK2, but insufficient to track the signal v(t) with a much larger band with the wanted accuracy. Therefore the presence of the sample&hold 6 is justified, even if sampling at the CK2 frequency, which has a larger bandwidth compatible with the fast variations of the signal v(t) to be pursued.

The logic unit 4 controls the adaptive operation of the calibration circuit of the Figures 1 and 2. First of all it takes care of the synchronization of the output words of both A/D converters 1 and 7, storing in turn one of **Q** words at the output of A/D converter 1 in a buffer register (not visible in the figures) controlled by the clock CK2 during all the duration of a period of said clock. Due to the synchronization, the N-bit word stored in the buffer will be made available when at the output of the second A/D converter 7 a word of N+M bits will be present which corresponds to the same analog level at the same time present at the input of both A/D converters (in other words the same sample). The other code words generated by the faster A/D converter 1 during the stay of the word in the memory register continue to flow on the ADD bus towards the RAM 8, or 9, being read at present. The two words of N and N+M bits previously synchronised are used for the writing of a look-up-table in the other one of the two RAMs 9, or 8, which at present is not on line; more precisely the N-bit word is used as an address for the writing position of the word of N+M bits. This single up-dating operation, also called mapping operation, is valid for all pairs of synchronised words.

The duration of the writing step of one RAM is timed by an updating clock whose frequency obtained through the division of clock CK2 is defined by statistic principles which will be illustrated in short. When said clock goes up the role of both RAMs will be exchanged, and the content of the RAM read on line up to this moment will now be updated through a new writing step. The means enabling this exchange of role are selectors, or demultiplexers, controlled by the updating clock. More exactly during the writing step:
- a first demultiplexer connects the bus DAT to the data input of one or the other of the memories 9, or 8;
- a second demultiplexer has in input the parallel outputs of the register which memorises one of **Q** words of N bits present on the bus ADD and it connects said outputs to the address input of one or the other of said memories; and
- a third demultiplexer sends to one or the other memory a writing enable strobe signal.
During the reading step on the other hand:
- a fourth demultiplexer connects the bus ADD to the address input of one or the other of the memories 9, or 8;
- a fifth demultiplexer connects the bus DAT of the output data of one or the other of said memories to user circuits placed downstream, that are not shown in any of the figures;
- a sixth demultiplexer sends a reading enable strobe signal to one or the other of the memories.

The determination of the clock frequency CK2 is the result of a compromise between the need to have a less expensive A/D converter 7 and therefore a slower one, and the opposed need to be able to complete in a minor real time the look-up-table (RAM) which corrects the codes generated by the first A/D converter 1. As already said, the recovery of the distortions introduced by the aging and thermal drift do not imply very urgent real time requirements, so that also a slow clock CK2 may be suitable for the scope. In this case, the signal converted by the device 7 would be unavoidably affected by spectral overlays due to the undersampling of the signal v(t), but this would not even in a minimal way influence the on-line operation, as the real signal v(t) is anyhow processed in the correct way by the A/D converter 1. Moreover, the correction of the codes may be also carried out in presence of alias; indeed a similar possibility could even accelerate the completion of the look-up table, as the amplitude dynamic of the signal v(t) reflected in the samples in output of the sample&hold 6 would turn out to be strengthened. Therefore the duration of the cycle for the updating of a look-up-table will depend - further obviously on the clock frequency CK2 - first of all on the above-mentioned dynamic. The determination of the clock frequency alternating the reading/writing steps in both RAMs 8 and 9, requires the statistic evaluation of the time variability of the levels of the signal v(t). Consequently the period of such updating clock is a casual variable depending on the cumulative probability of the amplitude distribution of the actual signal v(t), evaluated at the output of the second A/D converter 7. The prefigured confidence interval has to be very ample, near 99%, in order to avoid that some codes will not be updated for several consecutive cycles.

Although the invention has been described with particular reference to a preferred embodiment, it will be evident to those skilled in the art, that the present invention is not limited thereto, but further variations and modifications may be applied without departing from the scope thereof. It is thus contemplated that the present invention encompasses any and all such embodiments covered by the following claims.

## Claims

1. Circuit for linearizing the transfer characteristic of an analog-to-digital converter (1) timed by a first clock (CK1) for outputting first digital words (ADD) representing samples of an analog input signal (v(t)), comprising:
- a broadband sample-and-hold circuit (6) timed by a second clock (CK2) submultiple-Q of the first one (CK1) for capturing samples of the analog input signal (v(t));
- a reference analog-to-digital converter (7) placed downstream said broadband sample-and-hold circuit (6), timed by the second clock (CK2) for outputting second digital words (DAT) longer than said first digital words (ADD);
- a calibration stage (4, 8, 9) including a memory buffer adapted to receive said first digital words and to store in turn one out of Q first digital words (ADD_{LTC}) until the reference analog-to-digital converter (7) generates the second digital words (DAT) corresponding to the same sample of the analog input signal (v(t));
- memorization (8, 9) and logic means (4) inside the calibration stage adapted to receive said first digital words (ADD) and said second digital words (DAT), the one out of Q first digital words (ADD_{LTC}) made available at the output of said memory buffer, and outputting third digital words, the logic means being adapted to operate in cycles, each cycle including a writing and a reading operation;
**characterized in that** said memorization and logic means of the calibration stage comprise:
- a first random access memory (9, 8) for writing said second digital words (DAT) at the addresses corresponding to said one out of Q first digital words (ADD_{LTC}) made available at the output of said memory buffer;
- a second random access memory (8, 9) for reading and outputting said third digital words (DAT) at the addresses corresponding to the first digital words (ADD); and
- logic means (4) for cyclically alternating the writing and reading operations of the two random access memories in order to obtain that the second digital words (DAT) stored during a preceding cycle become the third digital words at a current cycle.

2. Linearization circuit of the preceding claim, **characterized in that** a period of said cyclic alternation is depending on both the frequency of said second clock (CK2) and the cumulative probability of the amplitude distribution of the analog input signal v(t) evaluated at the output of the reference analog-to-digital converter (7).

## Patentansprüche

1. Schaltung für die Linearisierung der Übertragungskennlinie eines A/D-Wandlers (1), zeitlich gesteuert durch einen ersten Takt (CK1) zur Ausgabe erster digitaler Wörter (ADD), die Samples eines analogen Eingangssignals (v(t)) repräsentieren, wobei die Schaltung Folgendes umfasst:
einen breitbandigen Abtast- und Haltekreis (6), der durch einen zweiten Takt (CK2), einen geradzahligen Teil Q des ersten Takts (CK1), gesteuert wird, um Samples des analogen Eingangssignals (v(t)) zu erfassen;
einen Referenz-A/D-Wandler (7), der in Abwärtsrichtung zu dem besagten breitbandigen Abtast- und Haltekreis (6) angeordnet ist und von dem zweiten Takt (CK2) gesteuert wird, um zweite digitale Wörter (DAT) auszugeben, die länger sind als die besagten ersten digitalen Wörter (ADD);
eine Kalibrierungsstufe (4, 8, 9), die einen Speicherpuffer umfasst, welcher dafür ausgelegt ist, die besagten ersten digitalen Wörter aufzunehmen und wechselweise eines von Q ersten digitalen Wörtern (ADD_{LTC}) zu speichern, bis der Referenz-A/D-Wandler (7) die zweiten digitalen Wörter (DAT) erzeugt hat, die demselben Sample des analogen Eingangssignals (v(t)) entsprechen;
Speicher- (8, 9) und ein Logikmittel (4) innerhalb der Kalibrierungsstufe, die dafür ausgelegt sind, die besagten ersten digitalen Wörter (ADD) und die besagten zweiten digitalen Wörter (DAT), das eine von Q ersten digitalen Wörtern (ADD_{LTC}), das am Ausgang des besagten Speicherpuffers zur Verfügung gestellt wird, zu empfangen und dritte digitale Wörter auszugeben, wobei das Logikmittel dafür ausgelegt ist, in Zyklen zu arbeiten, wobei jeder Zyklus einen Schreib- und einen Lese-Vorgang umfasst;
**dadurch gekennzeichnet, dass** die besagten Speicher- und Logikmittel der Kalibrierungsstufe Folgendes umfassen:
einen ersten Speicher mit wahlfreiem Zugriff (RAM) (9, 8) zum Schreiben der besagten zweiten digitalen Wörter (DAT) an den Adressen, die dem besagten einen aus Q ersten digitalen Wörtern (ADD_{LTC}), das am Ausgang des besagten Speicherpuffers zur Verfügung gestellt wird, entsprechen;
einen zweiten Speicher mit wahlfreiem Zugriff (RAM) (8, 9) zum Lesen und Ausgeben der besagten dritten digitalen Wörter (DAT) an den Adressen, die den besagten ersten digitalen Wörtern (ADD) entsprechen; und
ein Logikmittel (4) für das zyklische Wechseln der Schreib- und Lese-Vorgänge der beiden Speicher mit wahlfreiem Zugriff (RAM), um zu erreichen, dass die zweiten digitalen Wörter (DAT), die in einem vorangegangenen Zyklus gespeichert wurden, in einem aktuellen Zyklus zu den dritten digitalen Wörtern werden.

2. Linearisierungsschaltung gemäß dem vorstehenden Anspruch, **dadurch gekennzeichnet, dass** ein Zeitraum des besagten zyklischen Wechsels sowohl abhängig ist von der Frequenz des besagten zweiten Takts (CK2) als auch von der kumulativen Wahrscheinlichkeit der Amplitudenverteilung des analogen Eingangssignals v(t), das am Ausgang des Referenz-A/D-Wandlers (7) beurteilt wird.

## Revendications

1. Un circuit de linéarisation de la caractéristique de transfert d'un convertisseur analogique/numérique (1) minuté par une première horloge (CK1) pour produire les premiers mots numériques (ADD) représentant des échantillons d'un signal d'entrée analogique (v(t)), comprenant :
- un circuit échantillonneur-bloqueur à large bande (6) minuté par une seconde horloge (CK2) sous-multiple Q de la première horloge (CK1) pour la capture d'échantillons du signal d'entrée analogique (v(t)) ;
- un convertisseur analogique/numérique de référence (7) placé en aval dudit circuit échantillonneur-bloqueur à large bande (6), minuté par la seconde horloge (CK2) pour produire des deuxièmes mots numériques (DAT) plus longs que lesdits premiers mots numériques (ADD) ;
- une phase de calibration (4, 8, 9) comprenant une mémoire tampon adaptée pour recevoir lesdits premiers mots numériques et pour stocker à tour de rôle un des Q premiers mots numériques (ADD_{LTC}) jusqu'à ce que le convertisseur analogique/numérique de référence (7) génère les deuxièmes mots numériques (DAT) correspondant au même échantillon du signal d'entrée analogique (v(t)) ;
- des moyens de mémorisation (8, 9) et logiques (4) durant la phase de calibration, adaptés pour recevoir lesdits premiers mots numériques (ADD) et lesdits deuxièmes mots numériques (DAT), le mot parmi les Q premiers mots numériques (ADD_{LTC}) étant mis à disposition à la sortie de ladite mémoire tampon, et la production de troisièmes mots numériques, le moyen logique étant adapté pour fonctionner par cycles, chaque cycle comprenant une opération d'écriture et une opération de lecture ;
**caractérisée en ce que** lesdits moyens de mémorisation et moyens logiques de la phase de calibration comprennent :
- une première mémoire à accès aléatoire (9, 8) pour l'écriture desdits deuxièmes mots numériques (DAT) aux adresses correspondant audit mot parmi les Q premiers mots numériques (ADD_{LTC}) mis à disposition à la sortie de ladite mémoire tampon ;
- une seconde mémoire à accès aléatoire (8, 9) pour la lecture et la production desdits troisièmes mots numériques (DAT) aux adresses correspondant aux premiers mots numériques (ADD) ; et
- des moyens logiques (4) pour alterner cycliquement les opérations d'écriture et de lecture des deux mémoires à accès aléatoire afin d'obtenir que les deuxièmes mots numériques DAT enregistrés durant un cycle précédent deviennent les troisièmes mots numériques durant le cycle en cours.

2. Un circuit de linéarisation selon la revendication précédente, **caractérisé en ce qu'**une période de ladite alternance cyclique dépend à la fois de la fréquence de ladite seconde horloge (CK2) et de la probabilité cumulative de la distribution d'amplitude du signal d'entrée analogique v(t) évalué à la sortie du convertisseur analogique/numérique de référence (7).
